# EUROPÄISCHE PATENTSCHRIFT

(11) **EP 3 968 520 B1**
(45) Veröffentlichungstag und Bekanntmachung des Hinweises auf die Patenterteilung: **31.08.2022**
(21) Anmeldenummer: 20195414.6
(22) Anmeldetag: 10.09.2020
(51) Int. Cl.: H03K 17/95

(54) **SENSOR ZUR ERFASSUNG EINES OBJEKTS UND VERFAHREN ZUR AUSWERTUNG EINES SENSORSIGNALS**
SENSOR FOR DETECTING AN OBJECT AND METHOD FOR EVALUATING A SENSOR SIGNAL
CAPTEUR PERMETTANT DE DÉTECTER UN OBJET ET PROCÉDÉ D'ÉVALUATION D'UN SIGNAL DE CAPTEUR

(43) Veröffentlichungstag der Anmeldung: 16.03.2022
(73) Patentinhaber: SICK AG, 79183 Waldkirch (DE)
(72) Erfinder: Peter, Andreas, 79312 Emmendingen (DE); Thoss, Sascha, 79183 Waldkirch (DE); Machul, Olaf, 79294 Sölden (DE)

(56) Entgegenhaltungen:
- WO-A1-2014/146623
- DE-A1-102017 220 788
- US-A- 5 898 304
- US-A1- 2012 043 970
- POPPERLI MAXIMILIAN ET AL: "Capsule Neural Network based Height Classification using Low-Cost Automotive Ultrasonic Sensors", 2019 IEEE INTELLIGENT VEHICLES SYMPOSIUM (IV), IEEE, 9. Juni 2019 (2019-06-09), Seiten 661-666, XP033606011, DOI: 10.1109/IVS.2019.8813879 [gefunden am 2019-08-26]
- KÁNTOR ZOLTÁN ET AL: "Artificial Neural Network Assisted Compact Inductive Distance Sensor", PROCEDIA ENGINEERING, ELSEVIER BV, NL, Bd. 168, 4. Januar 2017 (2017-01-04), Seiten 23-26, XP029874621, ISSN: 1877-7058, DOI: 10.1016/J.PROENG.2016.11.121
- MEIER PHIL ET AL: "Compensation of Measurement Errors for a Magnetoresistive Angular Sensor Array Using Artificial Neuronal Networks", IEEE ACCESS, IEEE, USA, vol. 8, 24 July 2020 (2020-07-24), pages 142956-142976, XP011804597, DOI: 10.1109/ACCESS.2020.3012064

## Beschreibung

Die Erfindung betrifft einen induktiven Näherungssensor zur Erfassung eines Objekts und ein Verfahren zur Auswertung eines Sensorsignals eines induktiven Näherungssensors.

Sensoren, beispielsweise als berührungslose Schalter fungierende induktive Näherungssensoren, werden oft in rauer Umgebung eingesetzt. Ein wichtiges Qualitätsmerkmal ist dabei der maximal erreichbare Schaltabstand. Neben dem offensichtlichen Vorteil, dass ein Objekt schon in größeren Entfernungen detektiert werden kann, hat ein hoher Schaltabstand noch weitere Vorteile. Je höher der Schaltabstand des Sensors ist, desto größer kann der potentielle Abstand zum zu detektierenden Objekt sein. Dadurch verringert sich die Wahrscheinlichkeit von mechanischer Zerstörung. Ein weiterer Vorteil großer Schaltabstände ist die größere Einbautoleranz. Dadurch muss der Techniker bei der Montage des Sensors nicht so präzise arbeiten, was Zeit und Geld sparen sowie die Verfügbarkeit des Systems erhöhen kann. Wenn bei einem bestimmten Sensordurchmesser ein größerer Schaltabstand erreicht werden kann, lässt sich eine Detektionsaufgabe unter Umständen mit einem kleineren Sensor lösen, was häufig konstruktive Vorteile hat.

Ein weiteres wichtiges Qualitätsmerkmal induktiver Näherungssensoren ist neben dem für Stahl definierten Nennschaltabstand Sn auch die Größe des realen Schaltabstandes, der bei anderen Materialien erreicht wird. Diese Schaltabstände werden durch die sogenannten Reduktionsfaktoren charakterisiert. Idealerweise hat der Sensor den gleichen hohen Schaltabstand für beliebige Metalle. Die Reduktionsfaktoren haben in diesem Fall den Maximalwert 1 und werden deshalb auch F1 (Faktor 1) - Sensoren genannt.

Eine dritte wichtige Eigenschaft, die den Schaltabstand des Sensors beeinflusst, ist seine Empfindlichkeit gegenüber dem Einbau. Hier wäre das angestrebte Ideal ein Sensor, der völlig unempfindlich auf seine Einbautiefe und auf das Einbaumaterial ist, und immer seinen spezifizierten Schaltabstand behält. In der Realität besteht jedoch eine Einbauabhängigkeit, deren Effekt als Einbausprung bezeichnet wird.

Es sind induktive Näherungssensoren verfügbar, beispielsweise solche mit Kunststoffkappen, die zumindest bei einigen Bauformen den vierfachen Wert eines Standardnennschaltabstandes erreichen. Dabei handelt es sich um Sensoren, die nach dem klassischen Güteverfahren arbeiten. Der Nachteil dieser Sensoren besteht darin, dass sie kein F1-Verhalten besitzen. Da bei diesen Sensoren im Allgemeinen nur die Amplitude einer Sinusschwingung bei einer Frequenz als Information zur Verfügung steht, lässt sich dieser Nachteil auch nicht durch intelligente Algorithmen beheben.

Statt mit einer Sinusschwingung arbeiten manche induktiven Näherungssensoren mit einem Pulsverfahren. Ein Puls kann als Gemisch aus Sinussignalen unterschiedlicher Frequenz, Amplitude und Phasenlage betrachtet werden und liefert so zusätzliche Informationen. Solche Sensoren können nahezu ein F1-Verhalten zumindest bei Stahl und Aluminium aufweisen, haben jedoch immer noch eine relativ starke Einbauabhängigkeit.

Um den Einbausprung zu minimieren, gibt es Ansätze durch Zusatzmaßnahmen wie Folien, die um den Kernsatz gewickelt werden, oder zusätzliche Kompensationsspulen. Dadurch verringert sich die Empfindlichkeit gegenüber der Einbausituation, eine perfekte Kompensation des Einbausprungs gelingt jedoch nicht. Solche Hardwaremaßnahmen haben außerdem einen negativen Einfluss auf den Schaltabstand und erhöhen die Herstellkosten.

Hierzu seien einige Beispiele aus dem Stand der Technik genannt: Aus der DE 10 2006 053 023 B4 ist ein induktiver Näherungsschalter bekannt, der eine Hauptsendespule und eine diese koaxial umgebende Kompensationsspule mit entgegengesetzter Wicklung aufweist. Die DE 10 2007 027 822 A1 befasst sich mit einer induktiv arbeitenden Sensoranordnung mit einer Messspule und einer weiteren Spule. Die DE 10 2007 045 18 A1 beschreibt einen induktiven Näherungsschalter und eine Kernspule dafür, der mindestens zwei Sensorspulen zur Erfassung von Partialflüssen zugeordnet sind. In der DE 10 2017 109 813 A1 ist in einem induktiven Näherungsschalter eine Primärspule und eine Kompensationsspule mit separat steuerbarer Stromquelle vorgesehen. Die DE 10 2018 102 898 A1 offenbart einen Näherungssensor mit mehreren Spulen und extrahiert aus den Detektionsergebnissen einer Empfangsschaltung an den beiden Spulen eine erste Komponente, die durch einen Montagebeschlag, und eine zweite Komponente, die durch das Detektionsobjekt verursacht ist, wobei dann die zweite Komponente unter Verwendung der ersten Komponente kompensiert wird.

Praktisch sämtliche derzeit im Feld eingesetzten induktiven Näherungssensoren arbeiten mit klassischen Auswertungsverfahren, sei es das Güteverfahren mit der Sinusschwingung einer Frequenz oder das Pulsverfahren. Inzwischen gibt es auch erste Ansätze einer Auswertung durch Verfahren des maschinellen Lernens. Die Digitalisierung der Pulsantwort gemäß EP 3 282 586 B1, auch wenn sie dort in keinerlei Zusammenhang mit maschinellem Lernen gebracht wird, kann als eine Voraussetzung angesehen werden. Dadurch wird die gesamte Bandbreite der Verfahren der digitalen Signalverarbeitung zugänglich.

Die europäische Patentanmeldung EP 38 29 064 A1 beschreibt einen induktiven Näherungssensor, der ein Sensorsignal mit einem Referenzsignal zu einem Zwischensignal vorverarbeitet. Aus dem Zwischensignal wird dann mit einer gemäß einem Maschinenlernverfahren trainierten Auswerteeinheit der Ausgabewert des Sensors ermittelt.

Die WO2014/146623A1 befasst sich mit einem induktiven Wegmesssensor und einem Verfahren zu seinem Betrieb. Die Impulsantwort wird unmittelbar von einem künstlichen neuronalen Netzwerk ausgewertet. Das muss mit enormem Aufwand für jeden Sensor einzeln trainiert werden. Da die Impulsantwort unmittelbar ausgewertet wird und in der WO2014/146623A1 keinerlei intelligente Vorverarbeitung vorgeschlagen wird, lassen sich Toleranzunterschiede zwischen mehreren Sensoren gleichen Typs auch nicht eliminieren, so dass auf das Einzeltraining nicht verzichtet werden könnte. Sollte auch noch auf verschiedene Einbausituationen reagiert werden, was hier gar nicht diskutiert wird, so würde sich der ohnehin schon nicht handhabbare Trainingsaufwand für jeden einzelnen Sensor auch noch vervielfachen.

Aus der DE 44 33 772 A1 ist eine Sensoranordnung mit mindestens einer Messspule bekannt, deren Auswerteeinheit ein neuronales Netz aufweist, bei dem die Verknüpfungsgewichte zwischen dessen Schichten in einer Lernphase bestimmt und abgespeichert sind. Auch hier werden die Messsignale unmittelbar zum Lernen und zur Auswertung verwendet. Es wird für verschiedene Materialien trainiert, nicht aber für verschiedene Einbausituationen.

Die Arbeit von Käntor, Zoltán, and Zoltän Pólik. "Artificial neural network assisted compact inductive distance sensor." Procedia Engineering 168 (2016): 23-26 beschreibt einen materialunabhängigen, kompakten induktiven Distanzsensor. Auch hier werden die Signale mit einem künstlichen neuronalen Netzwerk ausgewertet, das je Sensor einzeln trainiert werden muss. Die nun mehrfach geschilderten Nachteile der Verwendung nicht vorverarbeiteter Signale, eines enormen und in der Massenfertigung nicht zu leistenden Trainingsaufwands sowie einer weiter bestehenden Empfindlichkeit für die konkrete Einbausituation sind nicht adressiert.

Aus der Arbeit Pöpperli, Maximilian, et al. "Capsule neural network based height classification using low-cost automotive ultrasonic sensors." 2019 IEEE Intelligent Vehicles Symposium (IV). IEEE, 2019 ist ein Ultraschallsensor bekannt, der mit Hilfe eines CNN (convoluted neural network) eine Höhenanalyse erfasster Objekte vornimmt.

Der Artikel Meier, Phil, et al. "Compensation of measurement errors for a magnetoresistive angular sensor array using artificial neuronal networks." IEEE Access 8 (2020): 142956-142976 befasst sich mit der verbesserten Bestimmung von Winkelpositionen eines magnetoresistiven Winkelsensors mit Hilfe künstlicher neuronaler Netze.

Die US 2012/0043970A1 offenbart eine automatische Anpassung eines kapazitiven Senors an erwartete Werte und Wertebereiche auf Basis gemessener Kapazitätswerte.

Es ist daher Aufgabe der Erfindung, die Auswertung eines Sensorsignals eines induktiven Näherungssensors zu verbessern.

Diese Aufgabe wird durch einen induktiven Näherungssensor zur Erfassung eines Objekts und ein Verfahren zur Auswertung eines Sensorsignals eines induktiven Näherungssensors nach Anspruch 1 beziehungsweise 14 gelöst. Der induktive Näherungssensor erfasst mit einer Erfassungseinheit ein Sensorsignal. Eine Steuer- und Auswertungseinheit bestimmt durch Auswertung des Sensorsignals eine Objekteigenschaft. Diese Auswertung erfolgt vorzugsweise mit klassischen Mitteln, also ohne ein Verfahren des maschinellen Lernens.

Die Erfindung geht von dem Grundgedanken aus, das Sensorsignal oder Teile des Sensorsignals ein weiteres Mal mit einem Verfahren des maschinellen Lernens auszuwerten. Ziel dieser Auswertung ist es, einen Korrekturwert für Störeinflüsse der Sensorumgebung zu bestimmen, der bei der Auswertung des Sensorsignals zur Bestimmung der Objekteigenschaft berücksichtigt wird beziehungsweise die Objekteigenschaft korrigiert. Es wird demnach mit einem Verfahren des maschinellen Lernens eine Schätzung der störenden Umgebungseinflüsse vorgenommen. Eine bevorzugte Implementierung teilt die Auswertung in einen Hauptpfad mit einem klassischen Verfahren zur Gewinnung der Objekteigenschaft und einen Korrekturpfad mit einem Verfahren des maschinellen Lernens. Dabei kann das klassische Verfahren das Sensorsignal mit einer einfachen Signalverarbeitung sehr schnell und das Verfahren des maschinellen Lernens auch komplex sein und langsamer erfolgen.

Die Erfindung hat den Vorteil, dass sich die drei einleitend diskutierten Kerneigenschaften eines induktiven Näherungssensors, nämlich hoher Schaltabstand, F1-Verhalten und geringe Einbauabhängigkeit, in einem Gerät vereinigen lassen beziehungsweise mindestens eine dieser Kerneigenschaften optimiert wird. Mit dem erfindungsgemäßen Sensorkonzept kann ein mindestens vierfacher Schaltabstand und zugleich ein F1-Verhalten wenigstens für Aluminium und Stahl erreicht werden. Diese Eigenschaften bleiben weitgehend unabhängig von Einbautiefe und Einbaumaterial erhalten. Ein Verfahren des maschinellen Lernens ermöglicht es allgemein, das Targetmaterial des erfassten Objekts zu erkennen, womit neben einem materialunabhängigen Schaltpunkt, also F1-Verhalten, auch eine gezielte Erkennung beispielsweise nur von ferromagnetischen Materialien unter Ausblendung von Buntmetallen möglich ist. Erfindungsgemäß genügt ein typspezifisches Training für eine ganze Klasse von Sensoren, ein sensorindividuelles Training ist nicht erforderlich.

Die Erfassungseinheit weist bevorzugt mindestens eine Spule auf. Damit erfasst ein induktiver Näherungssensor sein Sensorsignal. Noch bevorzugter weist die Erfassungseinheit genau eine Spule auf.

Der Sensor weist mindestens eine Spule zum Erzeugen eines Pulssignals auf. Dazu wird insbesondere die Spule mit einem Sendestromimpuls gespeist, der wiederum einen Spannungspuls als Sensorsignal induziert. Das wird auch als Pulsantwort bezeichnet. Mit einem Verfahren des maschinellen Lernens kann aus der Pulsantwort deutlich mehr Information gewonnen werden als beispielsweise nur aus einem Integralwert. Die Sendende Spule kann in einer Ausführungsform mit der empfangenden Spule identisch sein. In einer anderen Ausführungsform ist mindestens eine erste Spule zum Senden und eine zweite Spule der Empfangseinheit vorhanden, vorzugsweise genau eine zweite Spule der Empfangseinheit.

Der Sensor weist bevorzugt ein Zusatzelement auf, um Eigenschaften der Erfassungseinheit oder eines erzeugten Pulssignals zu verändern und so Zusatzinformation über die Sensorumgebung zu erfassen. Das durch Unterstützung des Zusatzelements gewonnene Sensorsignal wird zur Unterscheidung auch als Zusatzsignal bezeichnet. Es bleibt damit aber ebenfalls ein Sensorsignal, das in gleicher Weise ausgewertet werden kann, wobei tendenziell das Sensorsignal eher Informationen des gesuchten Messergebnisses und das Zusatzsignal Informationen über Störeinflüsse enthält. Diese Trennung ist aber nicht scharf, sowohl Sensorsignal als auch Zusatzsignal können je nach Ausführungsform sowohl zur Bestimmung der Objektinformation als auch des Korrekturwerts beitragen. Das Zusatzelement unterstützt die Schätzung des Korrekturwerts, weil der Sensor mehr über die Einbausituation erfährt. Es werden mit dem Zusatzelement zusätzliche Messungen durchgeführt oder die Messbedingungen variiert. Das Verfahren des maschinellen Lernens ist während des Trainings vorzugsweise mit diesen Zusatzinformationen konfrontiert worden. So lassen sich störende Einflüsse der Umgebung mit Hilfe des Korrekturwerts ausblenden, um in allen Einbausituationen einen hohen Schaltabstand gleichmäßig zu erhalten.

Das Zusatzelement ist bevorzugt eine Vertikalspule, eine Koaxialspule oder ein Kurzschlussring. Mit einer separaten Vertikalspule beziehungsweise einer separaten Koaxialspule erfolgt vorzugsweise eine eigene Pulsaussendung, die ein weiteres Sensorsignal erzeugt. In einer besonders bevorzugten Ausführungsform erfolgt die Pulsaussendung einerseits über die einzige Empfangsspule und andererseits über die zusätzliche Vertikalspule beziehungsweise Koaxialspule. Auch durch wahlweises Zuschalten eines Kurzschlussrings lassen sich zusätzliche Informationen gewinnen.

Die Steuer- und Auswertungseinheit ist bevorzugt dafür ausgebildet, als Objekteigenschaft ein binäres Objektfeststellungssignal zu bestimmen, wobei insbesondere der Sensor einen Schaltausgang aufweist, um das Objektfeststellungssignal als Schaltsignal auszugeben. Die Objekteigenschaft ist in diesem Fall eine binäre Anwesenheitsinformation "Objekt da"/"kein Objekt da", wobei die Anwesenheit noch bestimmten Bedingungen wie einem vorgegebenen Abstand oder einem bestimmten Material unterliegen kann. Der Sensor fungiert vorzugsweise als Schalter, der seinen Schaltausgang entsprechend dem binären Objektfeststellungssignal jeweils mit Eintritt oder Austritt eines Objektes umschaltet.

Der Erfassungseinheit ist vorzugsweise ein A/D-Wandler zur Digitalisierung des Sensorsignals zugeordnet. Das Sensorsignal kann dann digital weiterverarbeitet werden. Digitalisiert wird beispielsweise ein Abschnitt des Sensorsignals seit Anlegen des Sendestromimpulses bis zum Abklingen des induzierten Spannungspulses. Das digitalisierte Sensorsignal kann einerseits einfach weiterverarbeitet werden, beispielsweise durch Bilden eines Integralwertes, und andererseits kann ein Verfahren des maschinellen Lernens die Abtastwerte praktisch beliebig miteinander verrechnen und kombinieren und so aus einem Puls sehr viele Informationen gewinnen.

Die Steuer- und Auswertungseinheit ist bevorzugt dafür ausgebildet, aus einem Referenzsignal und dem Sensorsignal ein Zwischensignal zu erzeugen und die Objekteigenschaft und/oder den Korrekturwert anhand des Zwischensignals zu bestimmen. Das Zwischensignal wird dann weiterverarbeitet, dies ist weiterhin eine Auswertung des Sensorsignals als ursprüngliche Eingangsgröße. Das Referenzsignal ist bevorzugt ein zuvor aufgenommenes und abgespeichertes eigenes Sensorsignal des Sensors oder ein Sensorsignal eines Referenzsensors. Das eigene Sensorsignal, insbesondere ein eigener Referenzpuls, ist sensorspezifisch oder sensorindividuell aufgenommen und abgespeichert, beispielsweise bei der Herstellung. Ein solcher Schritt beispielsweise bei der Endprüfung ist im Gegensatz zu einem individuellen Training für ein Verfahren des maschinellen Lernens nicht zeitaufwändig. Alternativ ist denkbar, als Referenzsignal ein Sensorsignal eines Referenzsensors zu verwenden, der vorzugsweise baugleich oder vom gleichen Typ ist. Damit ist die Aufzeichnung eines Referenzsignals je individuellem Sensor nicht erforderlich. Es ist auch denkbar, dass mehrere Referenzsignale für unterschiedliche Anwendungssituationen gespeichert sind, zwischen denen durch Parametrisierung gewählt wird oder die in einer Mehrfachauswertung verwendet werden.

Die Steuer- und Auswertungseinheit ist bevorzugt dafür ausgebildet, einen Merkmalsvektor aus dem Sensorsignal zu erzeugen, insbesondere nach einer Transformation und/oder Dimensionsreduktion. Der Merkmalsvektor entspricht einer Vorverarbeitung des Sensorsignals und wird vorzugsweise von dem Verfahren des maschinellen Lernens zur Bestimmung des Korrekturwerts verwendet. Für das klassische Verfahren zur Auswertung kann der Merkmalsvektor ebenfalls verwendet werden, hier wird aber vorzugsweise das Sensorsignal beziehungsweise das digitalisierte Sensorsignal verarbeitet. Die Transformation ist beispielsweise eine Fouriertransformation, eine Wavelet-Transformation, eine Hadamardtransformation, eine diskrete Kosinustransformation oder eine Hauptkomponententransformation (PCA, Principal Component Analysis). In der Transformierten sind häufig die wesentlichen Informationen besser zu erfassen. Damit kann eine Dimensionsreduktion vorgenommen werden, bei der die zahlreichen Abtastpunkte auf die wesentlichen Merkmale reduziert werden. Diese Merkmale werden beispielsweise über eine Schwelle in der Transformierten gefunden. Der Merkmalsvektor kann auch aus mehreren Pulsantworten erzeugt werden.

Die Steuer- und Auswertungseinheit ist bevorzugt dafür ausgebildet, das Sensorsignal zu integrieren, insbesondere das integrierte Sensorsignal mit einem Schwellenwert zu vergleichen. Das betrifft das Verfahren zum Bestimmen der Objekteigenschaft mit klassischen Mitteln oder den Hauptpfad, nicht das Verfahren des maschinellen Lernens zum Auffinden des Korrekturwerts. Je nach Ausführungsform wird nicht das rohe Sensorsignal, sondern ein Vorverarbeitungsergebnis davon integriert. Der Integralwert wird dann vorzugsweise mit einem Schwellenwert verglichen, um ein binäres Objektfeststellungssignal oder Schaltsignal abzuleiten.

Der Korrekturwert ist bevorzugt ein Korrekturwert für das integrierte Sensorsignal. Das Verfahren des maschinellen Lernens ermittelt in dieser Ausführungsform einen Korrekturwert, der das Integral entsprechend der konkreten Sensorumgebung und Einbausituation korrigiert.

Die Steuer- und Auswertungseinheit ist bevorzugt für mindestens eines der folgenden Verfahren des maschinellen Lernens ausgebildet: ein lineares Modell, einen Entscheidungsbaum, ein neuronales Netz, eine Gaussprozess-Regression, ein k-nearest Neighbour-Verfahren oder eine support vector machine. Das passende Verfahren des maschinellen Lernens kann anhand der verfügbaren Auswertungsressourcen, Trainingsdaten und Erfordernisse der möglichen Anwendungen und Einbausituationen gewählt werden.

Das Verfahren des maschinellen Lernens ist bevorzugt mit Sensorsignalen in verschiedenen Sensorumgebungen trainiert, insbesondere unter Variation von Einbautiefe, Einbaumaterial, Objektabstand und Objektmaterial. Dadurch sind in dem Verfahren des maschinellen Lernens und dem damit bestimmten Korrekturwert wichtige Einflüsse der Sensorumgebung berücksichtigt, mit anderen Worten ist abgebildet, wie sich die Einbausituation auf verschiedene Detektionssituationen auswirkt. Dieses Training muss nicht je einzelnen Sensor ausgeführt werden, sondern kann für eine ganze Klasse von Sensoren erfolgen. Mit Toleranzen individueller Sensoren kann das Verfahren des maschinellen Lernens umgehen, und überdies ist möglich, die Toleranzen mit Hilfe eines individuellen Referenzsignals zumindest zu reduzieren.

Die Steuer- und Auswertungseinheit ist bevorzugt dafür ausgebildet, den Korrekturwert über die Zeit zu verfolgen und anhand seiner Historie anzupassen, insbesondere mit einem Prädiktionsfilter. Die Einbausituation und sonstige Sensorumgebung ist typischerweise recht stabil. Deshalb sind in der Vergangenheit bestimmte Korrekturwerte weiterhin zumindest eine gute Schätzung. Über einen Prädiktionsfilter lässt sich daher eine noch vorhandene Dynamik gut erfassen. Im einfachsten Fall wird lediglich ein Mittelwert oder ein gleitender Mittelwert gebildet, komplexere Prädiktionsfilter wie ein Kalmanfilter oder ein Wienerfilter sind auch möglich.

Bei dem erfindungsgemäßen Verfahren wird als Sensorsignal vorzugsweise ein Sensorsignal eines erfindungsgemäßen Sensors ausgewertet. Das Verfahren des maschinellen Lernens wird vorzugsweise vorab mit Sensorsignalen in verschiedenen Sensorumgebungen trainiert. Dabei wird besonders bevorzugt mindestens eine der Größen Einbautiefe, Einbaumaterial, Objektabstand und Objektmaterial variiert. Damit müssen nicht allzu viele Trainingssituationen gestellt werden, und dennoch werden die wesentlichen Einflüsse erfasst.

Das erfindungsgemäße Verfahren kann auf ähnliche Weise weitergebildet werden und zeigt dabei ähnliche Vorteile. Derartige vorteilhafte Merkmale sind beispielhaft, aber nicht abschließend in den sich an die unabhängigen Ansprüche anschließenden Unteransprüchen beschrieben.

Die Erfindung wird nachstehend auch hinsichtlich weiterer Merkmale und Vorteile beispielhaft anhand von Ausführungsformen und unter Bezug auf die beigefügte Zeichnung näher erläutert. Die Abbildungen der Zeichnung zeigen in:
- Fig. 1: eine Darstellung des beispielhaften Aufbaus eines erfindungsgemäßen Sensors;
- Fig. 2: eine Darstellung eines beispielhaften Sensorsignals, hier einer Pulsantwort, mit deren Digitalisierung;
- Fig. 3: eine Darstellung eines beispielhaften Merkmalsvektors aus dem Sensorsignal gemäß Figur 2;
- Fig. 4: ein beispielhaftes Ablaufdiagramm zur Bestimmung eines Schaltsignals mit Korrektur durch ein Verfahren des maschinellen Lernens;
- Fig. 5: eine dreidimensionale Ansicht einer zusätzlichen Vertikalspule zur verbesserten Erfassung der Sensorumgebung;
- Fig. 6: eine dreidimensionale Ansicht einer zusätzlichen Koaxialspule zur verbesserten Erfassung der Sensorumgebung;
- Fig. 7: eine dreidimensionale Ansicht eines zuschaltbaren Kurzschlussrings zur verbesserten Erfassung der Sensorumgebungen;
- Fig. 8: eine Darstellung von beispielhaften unkorrigierten Kennlinien eines induktiven Sensors bei verschiedenen Einbautiefen;
- Fig. 9: beispielhafte Darstellungen der Pulsantworten auf eine Sendespule und eine zusätzliche Spule;
- Fig. 10: eine Darstellung einer Transformierten zu den Pulsantworten gemäß Figur 9;
- Fig. 11: eine Darstellung eines beispielhaften, aus der Transformierten gemäß Figur 10 gewonnenen Merkmalsvektors; und
- Fig. 12: eine Darstellung ähnlich Figur 8 der nun korrigierten Kennlinien eines induktiven Sensors bei verschiedenen Einbautiefen.

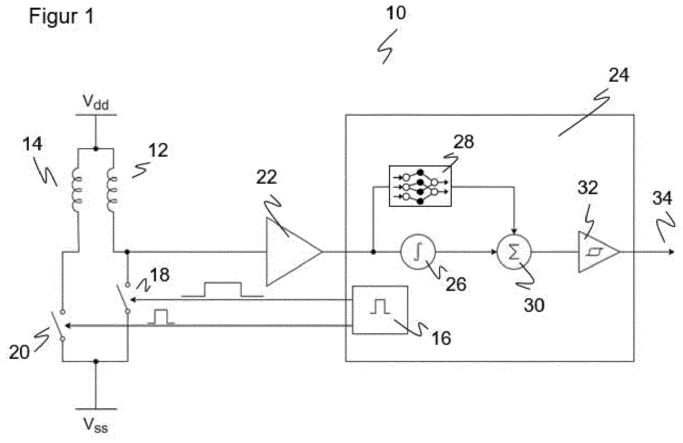

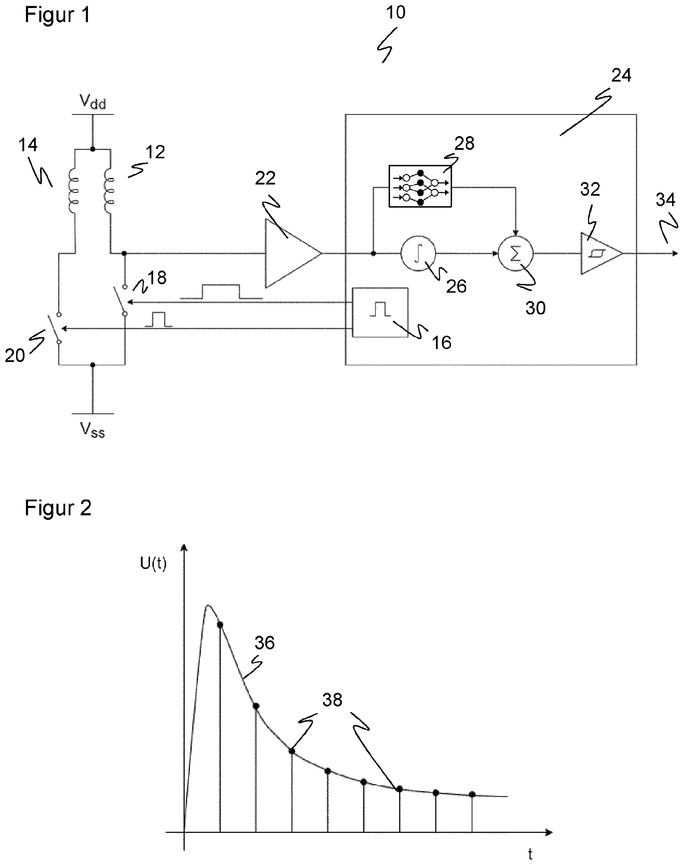

Figur 1 zeigt beispielhaft den Aufbau eines Sensors 10 in einer Ausführungsform der Erfindung. Der Sensor 10 umfasst eine Sende- und Empfangsspule 12 sowie eine Zusatzspule 14. Die beiden Spulen 12, 14 können von einer Spulenansteuerung 16 über einen ersten Schalter 18 beziehungsweise einen zweiten Schalter 20 mit einem Sendepuls angesteuert werden. Ein dadurch in der Sende- und Empfangsspule 12 induziertes Sensorsignal wird einem Ausleseverstärker und A/D-Wandler 22 zugeführt und dort digitalisiert. Die weitere digitale Verarbeitung erfolgt bevorzugt in Software beispielsweise auf einem Mikrocontroller, einem digitalen Signalprozessor, einem digitalen Signalcontroller oder einem sonstigen Verarbeitungsbaustein, der insgesamt als Steuer- und Auswertungseinheit 24 bezeichnet ist und auch die Spulenansteuerung 16 umfassen kann.

Das digitalisierte Sensorsignal wird auf einem geteilten Pfad einerseits in einem Hauptpfad mit einem klassischen Verfahren, der hier beispielhaft durch eine Integrationseinheit 26 repräsentiert ist, und andererseits in einem Korrekturpfad mit einem Verfahren des maschinellen Lernens ausgewertet, wobei eine dafür zuständige Korrekturwerteinheit 28 hier rein beispielhaft als neuronales Netz dargestellt ist. In einer Kombiniereinheit 30 wird das Integral der Integrationseinheit 26 um einen Korrekturwert der Korrekturwerteinheit 28 korrigiert. Je nach klassischen Verfahren und Verfahren des maschinellen Lernens kann diese Korrektur auch komplexer sein. Das korrigierte Integral wird in einer Schaltlogik 32 mit einer Schaltschwelle verglichen, vorzugsweise unter Berücksichtigung einer Hysterese, und der Sensor 10 gibt ein entsprechendes Schaltsignal an einem oder mehreren Schaltausgängen 34 aus. Andere Ausführungsformen des Sensors 10 erzeugen aus dem Sensorsignal statt eines Schaltsignals eine andere Objektinformation.

Figur 2 zeigt ein beispielhaftes Sensorsignal 36 des Sensors 10. Vorzugsweise arbeitet der Sensor 10 mit Pulsen: In der Sende- und Empfangsspule 12 und/oder der Zusatzspule 14 wird über die Schalter 18, 20 ein Strompuls ausgelöst, und als Pulsantwort wird ein Spannunaspuls in der Sende- und Empfanasspule 12 induziert, wie er beispielhaft in Figur 2 dargestellt ist. Der Sensor 10 arbeitet also in der bevorzugten Ausführungsform mit zwei Sendespulen und genau einer Empfangsspule, wobei die Sende- und Empfangsspule 12 eine Doppelfunktion hat. Das Sensorsignal 36 wird an Abtastpunkten 38 abgetastet und so digitalisiert.

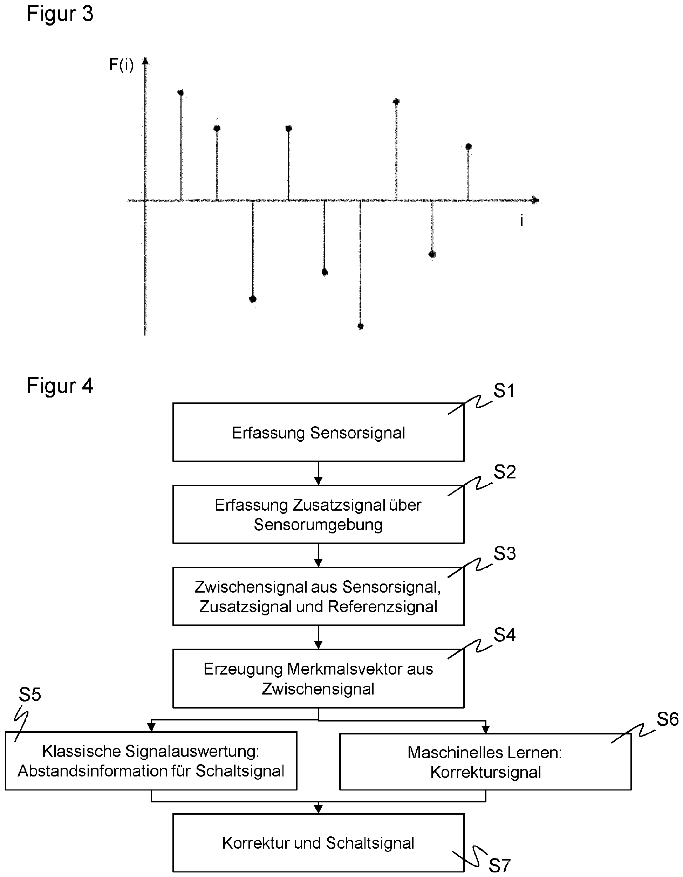

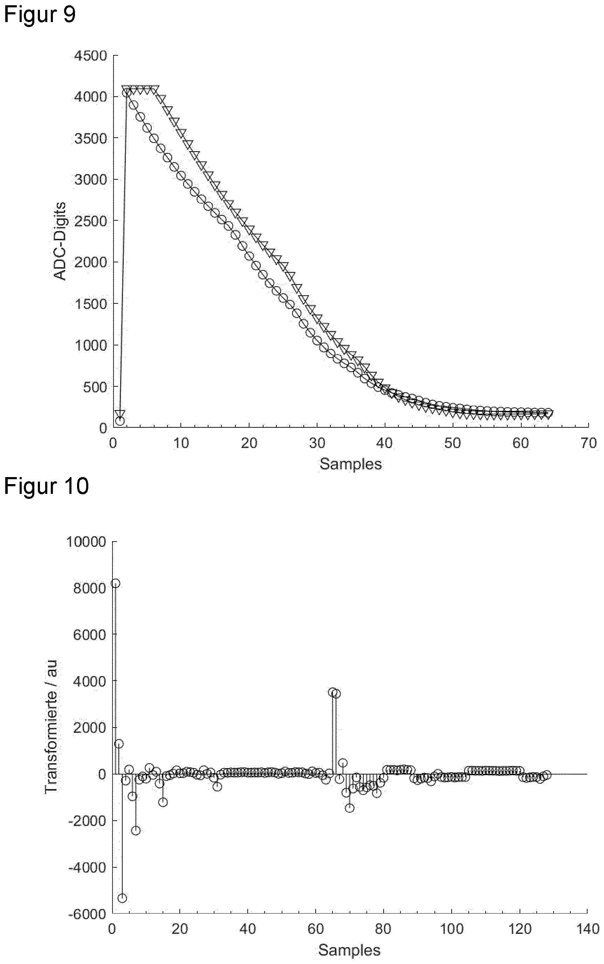

Figur 3 zeigt einen Merkmalsvektor, der aus dem digitalisierten Sensorsignal 36 gewonnen wird. Dadurch wird die relevante Information weiter verdichtet oder anders ausgedrückt eine Dimensionsreduktion vorgenommen. Die Merkmale werden vorzugsweise nicht aus dem Sensorsignal 36 selbst, sondern einer Transformierten davon gewonnen. Das wird später unter Bezugnahme auf die Figuren 9 bis 11 an einem Beispiel näher erläutert.

Figur 4 zeigt ein beispielhaftes Ablaufdiagramm für die Auswertung eines Sensorsignals mit dem Sensor 10 gemäß Figur 1. Der Ablauf wird mit einem pulsbasierten Verfahren beschrieben, die Erfindung ist aber auch für andere Verfahren anwendbar.

In einem Schritt S1 wird ein Sensorsignal erfasst, indem die Sende- und Empfangsspule 12 einen Puls erzeugt und der dadurch in der Sende- und Empfangsspule 12 induzierte Puls aufgenommen, verstärkt und digitalisiert wird.

Entsprechend wird in einem Schritt S2 ein als Zusatzsignal bezeichnetes weiteres Sensorsignal erfasst, um Informationen über die Sensorumgebung zu gewinnen, indem die Zusatzspule 14 einen Puls erzeugt und der dadurch in der Sende- und Empfangsspule 12 induzierte Puls aufgenommen, verstärkt und digitalisiert wird. Je nach Ausführungsform kann der Schritt S2 entfallen oder das Zusatzsignal die Pulsantwort auf einen zugleich in der Sende- und Empfangsspule 12 und der Zusatzspule 14 erzeugten Puls sein. Prinzipiell ist auch denkbar, nur die Pulsantwort auf einen Puls der Zusatzspule 14 gemäß Schritt S2 auszuwerten und somit den Schritt S1 zumindest zeitweise wegzulassen.

In einem optionalen, aber sehr hilfreichen Schritt S3 wird ein Zwischensignal aus dem Sensorsignal und einem Referenzsignal erzeugt. Sofern im Schritt S2 ein Zusatzsignal aufgenommen wurde, wird auch hierfür vorzugsweise ein Zwischensignal aus dem Zusatzsignal und einem weiteren Referenzsignal erzeugt. Das jeweilige Zwischensignal ersetzt oder ergänzt dann für die weitere Auswertung das ursprüngliche Sensorsignal beziehungsweise Zusatzsignal. Das Referenzsignal ist ein zuvor in dem Sensor 10 abgespeicherter Puls, der vorzugsweise für genau diesen individuellen Sensor 10 in einer beispielsweise hinsichtlich Einbau, Einbaumaterial, Targetabstand und Targetmaterial definierten Umgebung gewonnen wurde. Alternativ ist es ein Referenzsignal, das stellvertretend und allgemeiner für eine Klasse von Sensoren bestimmt wurde. Die Kompensation mit dem Referenzsignal funktioniert sehr gut durch Differenzbildung, ohne damit komplexere Kompensationen auszuschließen. Die Berücksichtigung eines Referenzsignals wird in der einleitend schon genannten noch unveröffentlichten europäischen Patentanmeldung mit dem Aktenzeichen 19 212 336.2 weiter erläutert.

In einem Schritt S4 wird aus dem Zwischensignal ein Merkmalsvektor gebildet. Ein sehr einfacher Merkmalsvektor besteht direkt aus den Abtastpunkten. Das erfordert aber eine unangenehm hochdimensonale weitere Analyse. Deshalb wird das Zwischensignal vorzugsweise transformiert, beispielsweise durch eine Fouriertransformation, eine Wavelet-Transformation, eine Hadamardtransformation, eine diskrete Kosinustransformation oder eine Hauptkomponentenanalyse (PCA, Principal Component Analysis). Anschließend können in der Transformierten diejenigen Werte beispielsweise mit einer Schwellenoperation aufgefunden werden, die vermutlich die meiste relevante Information tragen. Aus diesen Werten setzt sich dann der Merkmalsvektor zusammen.

Die Schritte S3 und S4 werden vorzugsweise in Software in der Steuer- und Auswertungseinheit 24 durchgeführt. In Figur 1 wäre ein entsprechender Funktionsblock nach dem A/D-Wandler 22 und vor der Integrationseinheit 26 beziehungsweise der Korrekturwerteinheit 28 anzuordnen.

In einem Schritt S5 erfolgt eine klassische Signalauswertung, um eine Abstandsinformation eines erfassten Objekts beziehungsweise ein Schaltsignal zu gewinnen. Dazu wird beispielsweise das Sensorsignal und/oder das Zusatzsignal integriert. Der klassischen Signalauswertung kann der Merkmalsvektor aus Schritt S4 zugrunde liegen. Alternativ basiert die klassische Signalauswertung auf dem Sensorsignal und/oder dem Zusatzsignal selbst, wobei aber vorzugsweise das Referenzsignal gemäß Schritt S3 berücksichtigt ist. Das entspricht dem Hauptpfad mit der Integriereinheit 26 in Figur 1. Integration ist nur ein Beispiel für eine klassische Signalauswertung.

In einem Schritt S6 erfolgt eine Auswertung mit einem Verfahren des maschinellen Lernens, um einen Korrekturwert zu gewinnen, der die Sensorumgebung und speziell dessen Einbausituation berücksichtigt. Der Bestimmung des Korrekturwerts steht aufgrund des Zusatzsignals zusätzliche Information über die Sensorumgebung zur Verfügung. Es sind je nach Sensor 10, Anwendungsfeldern und denkbaren Sensorumgebungen verschiedene Verfahren des maschinellen Lernens geeignet, beispielsweise ein lineares Modell, ein Entscheidungsbaum, ein neuronales Netz, eine Gaussprozess-Regression, ein k-nearest Neighbour-Verfahren oder eine support vector machine.

In einem Schritt S7 wird das Ergebnis der klassischen Signalauswertung mit dem Korrekturwert korrigiert, der mit einem Verfahren des maschinellen Lernens gewonnen ist. Beispielsweise wird der Korrekturwert von dem Integral abgezogen und der so korrigierte Wert mit einer Schaltschwelle verglichen, um ein Schaltsignal zu gewinnen. Bei einer anderen klassischen Signalauswertung als über ein Integral sind andere Korrekturwerte und andere Arten denkbar, die klassische Signalauswertung mit dem Korrekturwert zu korrigieren.

Der Ablauf gemäß Figur 4 wird dann zyklisch wiederholt, damit der Sensor 10 jeweils ein aktuelles Schaltsignal an seinem Schaltausgang 34 bereitstellt.

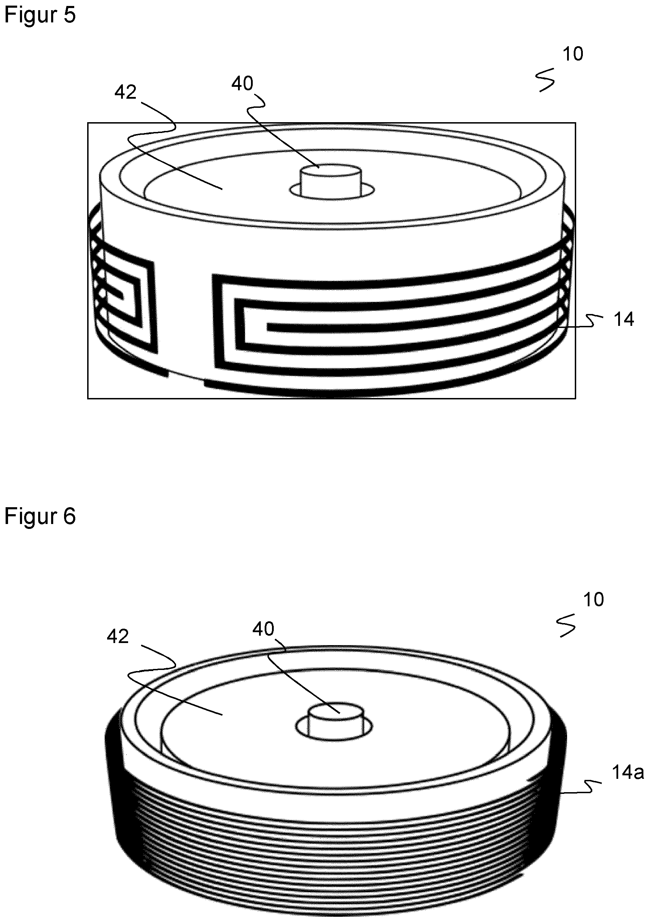

Um die störenden Umgebungseinflüsse besser bestimmen zu können, ist es vorteilhaft, durch zusätzliche Messungen gezielt die Sensorumgebung zu erfassen. In Figur 1 ist zu diesem Zweck die Zusatzspule 14 vorgesehen. Sie ist dort aber nur symbolisch und in ihrer Verschaltung gezeigt. In den Figuren 5 bis 7 sind konkrete Implementierungsbeispiele für Elemente zur Erfassung eines Zusatzsignals dargestellt.

Figur 5 zeigt eine dreidimensionale Ansicht einer Vertikalspule als Zusatzspule 14. Der Sensor 10 hat als Ganzes typischerweise eine zylindrische Form. Gezeigt ist ein Ferrit 40 mit einer Spule 42, die als Sende- und Empfangsspule 12 fungiert. Die separate Vertikalspule 14 regt die Umgebung des Sensors 10 stärker an als das zu erfassende Objekt oder Target und erzeugt somit Information über die Sensorumgebung.

Figur 6 zeigt eine dreidimensionale Ansicht einer nun alternativ als Koaxialspule um den Kernsatz ausgebildeten Zusatzspule 14a. Die Koaxialspule erfährt eine andere Durchflutung vom Magnetfeld des Targets und des Einbaus und ermöglicht so eine Unterscheidung zwischen eigentlichem Messsignal und Einflüssen der Umgebung.

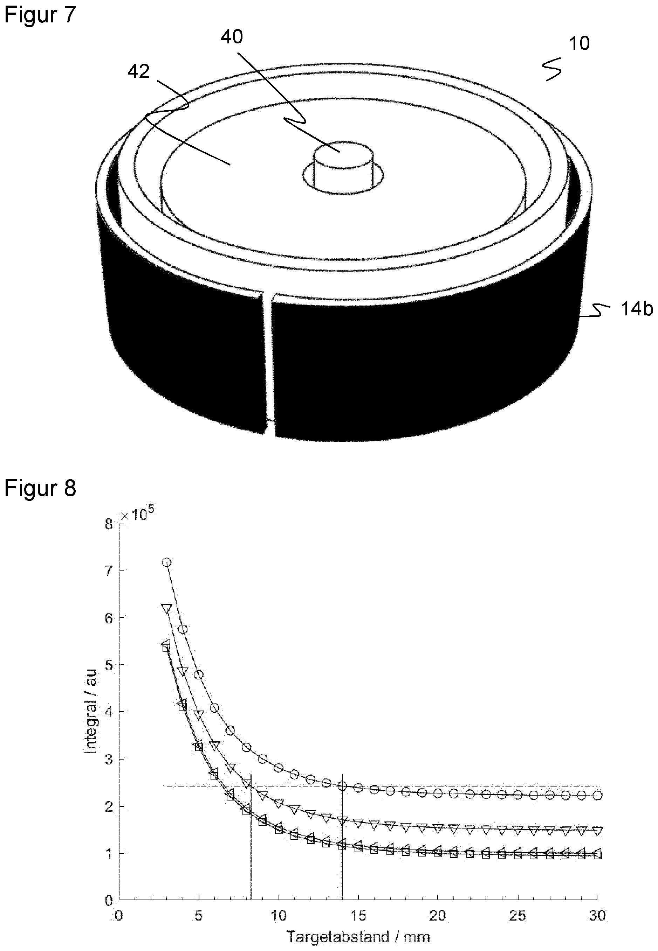

Figur 7 zeigt eine dreidimensionale Ansicht mit einer weiteren Alternativen in Form eines schaltbaren Kurzschlussrings 14b. Der Kurzschlussring 14b ist keine Spule, erfüllt aber eine ganz ähnliche Funktion wie die Zusatzspule 14. Wird der Kurzschlussring 14b alternierend der Messung zugeschaltet, so wird dadurch das Magnetfeld in der Umgebung des Einbaus des Sensors 10 zwischen 2 Messungen verändert.

Das Training und die spätere Anwendung der erfindungsgemäßen Korrektur durch ein Verfahren des maschinellen Lernens sollen nun an beispielhaften Daten unter Bezugnahme auf die Figuren 8 bis 12 illustriert werden. Figur 8 zeigt zunächst zum Vergleich unkorrigierte Kennlinien des Sensors 10, wenn also einfach das unkorrigierte Integral der klassischen Signalauswertung zugrunde gelegt wird. Die Kennlinien sind für verschiedene Einbautiefen bestimmt und jeweils durch unterschiedliche Symbole der Datenpunkte dargestellt. Die gestrichelte horizontale Linie entspricht der Schaltschwelle. Ein Werksabgleich hat bei einer bestimmten Einbautiefe stattgefunden und zu einem Schaltabstand von 14 mm entsprechend der rechten senkrechten Linie geführt. Wird der Sensor 10 dann aber bei einer größeren Einbautiefe betrieben, so verringert sich der Schaltabstand in diesem Beispiel auf nur noch 8,2 mm entsprechend linken senkrechten Linie. Ohne die erfindungsgemäße Korrektur ist folglich der Sensor 10 alles andere als unabhängig von seiner Einbausituation.

Für das Training des Verfahrens des maschinellen Lernens werden Trainingsdaten erzeugt. Erfindungsgemäß muss das Training nicht individuell für jeden Sensor 10 durchgeführt werden, sondern ein Sensor einer Bauform oder Klasse von Sensoren kann stellvertretend trainiert werden. Dabei ist denkbar, mit mehreren Sensoren zu trainieren und so die zu erwartenden Toleranzen besser abzudecken. Für die Erfassung der Trainingsdaten wird der Sensor in verschiedene Einbausituationen und Detektionssituationen gebracht. Dazu werden die Einbaumaterialien, die Einbautiefe, das Material und der Abstand des zu erfassenden Objekts beziehungsweise Targets variiert. Je mehr mögliche Situationen abgedeckt werden und je feiner die Schrittweite für Einbautiefe und Abstand, desto genauer werden die Trainingsdaten, aber zugleich erhöht sich auch die Datenmenge und damit der Aufwand für Training und Bestimmung des Modells für das Verfahren des maschinellen Lernens. Es wird jeweils eine Pulsantwort auf einen Puls der Sende- und Empfangsspule 12 und der Zusatzspule 14 aufgenommen. Ein Beispiel ist in Figur 9 mit Kreisen für das eigentliche Sensorsignal und mit Dreiecken für das Zusatzsignal gezeigt. Es ist denkbar, mehrere Trainingssituationen gleichzeitig zu stellen, indem ein Targetdurchlauf mit mehreren Sensoren beispielsweise in unterschiedlichen Einbautiefen oder Einbaumaterialien gleichzeitig vermessen wird.

Im Zuge der Erfassung von Trainingsdaten kann auch das im optionalen Schritt S3 der Figur 4 benötigte Referenzsignal aufgenommen werden. Dem Referenzsignal liegt vorzugsweise eine feste Detektionssituation zugrunde, etwa maximaler Targetabstand und maximale Einbautiefe bei einem bestimmten Einbaumaterial und Targetmaterial. Das Referenzsignal kann jeweils für die Pulsantwort der Sende- und Empfangsspule 12 und der Zusatzspule 14 aufgenommen und im Schritt S3 vom jeweiligen Sensorsignal beziehungsweise Zusatzsignal abgezogen werden.

Die beispielhaft in Figur 9 gezeigten Pulsantworten, die vorzugsweise jeweils durch das zugehörige Referenzsignal korrigiert sind, werden nun einer Transformation unterzogen, wobei oben Beispiele geeigneter Transformationen genannt sind. Eine Transformierte ist in Figur 10 dargestellt. Es wird in Figur 10 nicht zwischen Sensorsignal und Zusatzsignal unterschieden, vorzugsweise wird jeweils separat transformiert und zu einem Vektor zusammengefasst.

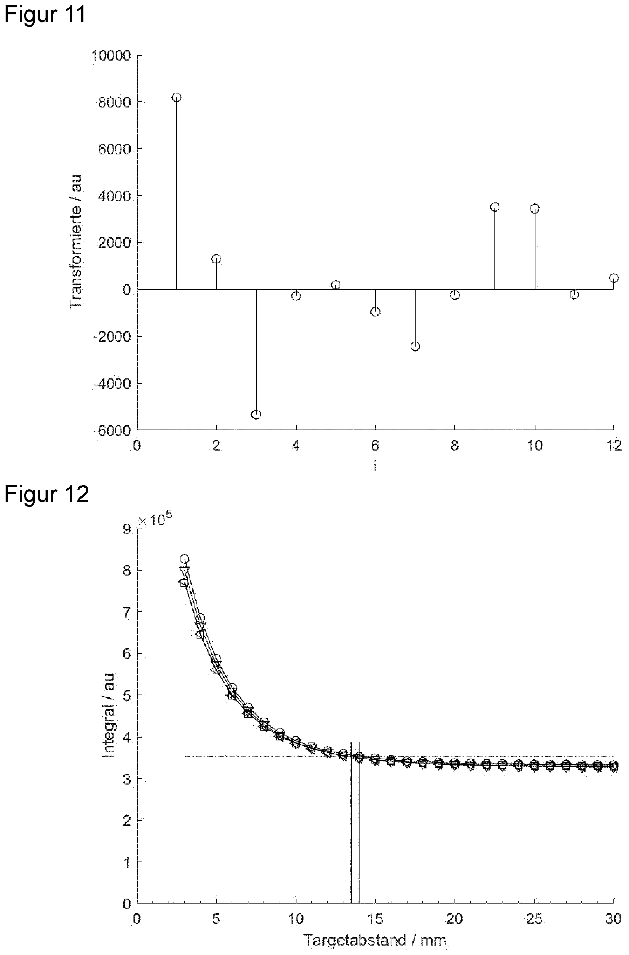

Figur 11 illustriert einen aus der Transformierten extrahierten Merkmalsvektor. Es werden vorteilhafterweise die Transformierten mit der größten Varianz über alle Trainingsdaten ausgewählt, um daraus den Merkmalsvektor zu bilden. Zur Dimensions- oder Datenreduktion werden nur die Werte als Merkmale für ein Modell ausgewählt, deren Varianz über den gesamten Datensatz eine definierte Schwelle überschreitet. Daher enthält der Merkmalsvektor gemäß Figur 11 deutlich weniger Elemente als die Transformierte gemäß Figur 10.

Jedem in dieser Weise aus den Trainingsdaten gewonnenen Merkmalsvektor wird ein Korrektursollwert Y zugeordnet, der dem gewünschten Korrekturwert bei dieser Detektions- und Einbausituation entspricht. Es entstehen demnach annotierte oder gelabelte Trainingsdaten für ein überwachtes Lernen. Damit kann im Prinzip jedes Verfahren des maschinellen Lernens trainiert werden, von denen oben einige aufgezählt wurden. Im Betrieb werden die trainierten Koeffizienten oder Gewichte mit dem Merkmalsvektor einer jeweiligen neuen Messung verrechnet, um den gesuchten Korrekturwert zu erhalten, der dann beispielsweise zu einem Integralwert einer klassischen Signalauswertung addiert oder davon abgezogen wird. Vorzugsweise wird jeweils ein eigenes Modell je Bauform oder Klasse des Sensors 10 erstellt und trainiert.

Figur 12 zeigt in einer Darstellung ähnlich der Figur 8 die Kennlinien eines Sensors 10, die nach Abschluss des Trainings mit dem Verfahren des maschinellen Lernens korrigiert sind. Die beiden senkrechten Linien für den Schaltabstand bei Werksabgleich auf 14 mm und bei gegenüber dem Werksabgleich veränderter Einbautiefe liegen nun beinahe übereinander, der Schaltpunkt liegt bei 13,5 mm und hat sich dank der erfindungsgemäßen Korrektur kaum noch verschoben.

Zusammenfassend liegt die Idee der Erfindung darin, ein Verfahren des maschinellen Lernens nicht allein und schon gar nicht wie im Stand der Technik auf Basis der rohen Sensorsignale einzusetzen. Vielmehr ergänzt das maschinelle Lernen eine herkömmliche Signalauswertung, wobei das maschinelle Lernen für die Erfassung der störenden Sensorumgebung und des daraus ermittelbaren Korrekturwertes zuständig ist. Durch diese Aufteilung hängt auch die grundsätzliche Funktionsfähigkeit des erfindungsgemäßen Sensors nicht allein vom maschinellen Lernen ab. Der Korrekturwert kann in langsameren Zyklen und dadurch mit weniger Rechenressourcen erfasst werden. Es ist kein sensorindividuelles Training erforderlich, und Toleranzen zwischen einzelnen Sensoren einer Klasse können durch Referenzsignale ausgeglichen werden. Der Aufwand hierfür ist unvergleichlich viel kleiner, als alle Detektionssituationen speziell für jeden einzelnen Sensor abdecken zu müssen.

## Patentansprüche

1. Induktiver Näherungssensor (10) zur Erfassung eines Objekts, wobei der induktive Näherungssensor (10) eine Erfassungseinheit (12, 22) zum Erfassen eines Sensorsignals und eine Steuer- und Auswertungseinheit (24) aufweist, die dafür ausgebildet ist, durch Auswertung des Sensorsignals eine Objekteigenschaft zu bestimmen, wobei die Steuer- und Auswertungseinheit (24) eine Korrekturwerteinheit (28) aufweist, die dafür ausgebildet ist, aus dem Sensorsignal durch eine weitere Auswertung mit einem Verfahren des maschinellen Lernens einen Korrekturwert für Störeinflüsse der Sensorumgebung zu bestimmen und die Objekteigenschaft mit dem Korrekturwert zu korrigieren.

2. Induktiver Näherungssensor (10) nach Anspruch 1,
wobei die Erfassungseinheit (12, 22) mindestens eine Spule (12) aufweist.

3. Induktiver Näherungssensor (10) nach Anspruch 1 oder 2,
der mindestens eine Spule (12, 14) zum Erzeugen eines Pulssignals aufweist.

4. Induktiver Näherungssensor (10) nach einem der vorhergehenden Ansprüche, der ein Zusatzelement (14, 14a, 14b) aufweist, um Eigenschaften der Erfassungseinheit oder, wenn rückbezogen auf Anspruch 3, eines erzeugten Pulssignals zu verändern und so Zusatzinformation über die Sensorumgebung zu erfassen.

5. Induktiver Näherungssensor (10) nach Anspruch 4,
wobei das Zusatzelement (14, 14a, 14b) eine Vertikalspule (14), eine Koaxialspule (14a) oder ein Kurzschlussring (14b) ist.

6. Induktiver Näherungssensor (10) nach einem der vorhergehenden Ansprüche, wobei die Steuer- und Auswertungseinheit (24) dafür ausgebildet ist, als Objekteigenschaft ein binäres Objektfeststellungssignal zu bestimmen, wobei insbesondere der Sensor (10) einen Schaltausgang (34) aufweist, um das Objektfeststellungssignal als Schaltsignal auszugeben.

7. Induktiver Näherungssensor (10) nach einem der vorhergehenden Ansprüche, wobei der Erfassungseinheit (12, 22) ein A/D-Wandler (22) zur Digitalisierung des Sensorsignals zugeordnet ist.

8. Induktiver Näherungssensor (10) nach einem der vorhergehenden Ansprüche, wobei die Steuer- und Auswertungseinheit (24) dafür ausgebildet ist, aus einem Referenzsignal und dem Sensorsignal ein Zwischensignal zu erzeugen und die Objekteigenschaft und/oder den Korrekturwert anhand des Zwischensignals zu bestimmen, wobei das Referenzsignal ein zuvor aufgenommenes und abgespeichertes eigenes Sensorsignal des Sensors (10) oder ein Sensorsignal eines Referenzsensors ist.

9. Induktiver Näherungssensor (10) nach einem der vorhergehenden Ansprüche, wobei die Steuer- und Auswertungseinheit (24) dafür ausgebildet ist, einen Merkmalsvektor aus dem Sensorsignal zu erzeugen, insbesondere nach einer Transformation und/oder Dimensionsreduktion.

10. Induktiver Näherungssensor (10) nach einem der vorhergehenden Ansprüche, wobei die Steuer- und Auswertungseinheit (24) dafür ausgebildet ist, das Sensorsignal zu integrieren, insbesondere das integrierte Sensorsignal mit einem Schwellenwert zu vergleichen, wobei insbesondere der Korrekturwert ein Korrekturwert für das integrierte Sensorsignal ist.

11. Induktiver Näherungssensor (10) nach einem der vorhergehenden Ansprüche, wobei die Steuer- und Auswertungseinheit (24) für mindestens eines der folgenden Verfahren des maschinellen Lernens ausgebildet ist: ein lineares Modell, einen Entscheidungsbaum, ein neuronales Netz, eine Gaussprozess-Regression, ein k-nearest Neighbour-Verfahren oder eine support vector machine.

12. Induktiver Näherungssensor (10) nach einem der vorhergehenden Ansprüche, wobei das Verfahren des maschinellen Lernens mit Sensorsignalen in verschiedenen Sensorumgebungen trainiert ist, insbesondere unter Variation von Einbautiefe, Einbaumaterial, Objektabstand und Objektmaterial.

13. Induktiver Näherungssensor (10) nach einem der vorhergehenden Ansprüche, wobei die Steuer- und Auswertungseinheit (24) dafür ausgebildet ist, den Korrekturwert über die Zeit zu verfolgen und anhand seiner Historie anzupassen, insbesondere mit einem Prädiktionsfilter.

14. Verfahren zur Auswertung eines Sensorsignals eines induktiven Näherungssensors (10), wobei das Sensorsignal erfasst und ausgewertet wird, um eine Objekteigenschaft zu bestimmen, wobei aus dem Sensorsignal in einer weiteren Auswertung mit einem Verfahren des maschinellen Lernens ein Korrekturwert für Störeinflüsse der Sensorumgebung bestimmt und die Objekteigenschaft mit dem Korrekturwert korrigiert wird.

15. Verfahren nach Anspruch 14,
wobei vorab das Verfahren des maschinellen Lernens mit Sensorsignalen in verschiedenen Sensorumgebungen trainiert wird, insbesondere unter Variation von Einbautiefe, Einbaumaterial, Objektabstand und Objektmaterial.

## Claims

1. An inductive proximity sensor (10) for detecting an object, the inductive proximity sensor (10) comprising a detection unit (12, 22) for detecting a sensor signal and a control and evaluation unit (24) configured to determine an object property by evaluating the sensor signal, the control and evaluation unit (24) comprising a correction value unit (28) configured to determine a correction value for disturbing influences of the sensor environment from the sensor signal by further evaluation using a machine learning method and to correct the object property using the correction value.

2. The inductive proximity sensor (10) according to claim 1,
wherein the detection unit (12, 22) comprises at least one coil (12).

3. The inductive proximity sensor (10) according to claim 1 or 2,
comprising at least one coil (12, 14) for generating a pulse signal.

4. The inductive proximity sensor (10) according to any of the preceding claims, comprising an additional element (14, 14a, 14b) for changing characteristics of the sensing unit or, when referred back to claim 3, of a generated pulse signal, and thus to detect additional information about the sensor environment.

5. The inductive proximity sensor (10) according to claim 4,
wherein the additional element (14, 14a, 14b) is a vertical coil (14), a coaxial coil (14a) or a shorting ring (14b).

6. The inductive proximity sensor (10) according to any of the preceding claims, wherein the control and evaluation unit (24) is configured to determine a binary object detection signal as an object property, wherein in particular the sensor (10) comprises a switching output (34) to output the object detection signal as a switching signal.

7. The inductive proximity sensor (10) according to any of the preceding claims, wherein the detection unit (12, 22) is associated with an A/D converter (22) for digitizing the sensor signal.

8. The inductive proximity sensor (10) according to any of the preceding claims, wherein the control and evaluation unit (24) is configured to generate an intermediate signal from a reference signal and the sensor signal and to determine the object property and/or the correction value on the basis of the intermediate signal, wherein the reference signal is a previously recorded and stored sensor signal of the sensor (10) or a sensor signal of a reference sensor.

9. The inductive proximity sensor (10) according to any of the preceding claims, wherein the control and evaluation unit (24) is configured to generate a feature vector from the sensor signal, in particular after a transformation and/or dimensional reduction.

10. The inductive proximity sensor (10) according to any of the preceding claims, wherein the control and evaluation unit (24) is configured to integrate the sensor signal, in particular to compare the integrated sensor signal with a threshold value, wherein in particular the correction value is a correction value for the integrated sensor signal.

11. The inductive proximity sensor (10) according to any of the preceding claims, wherein the control and evaluation unit (24) is configured for at least one of the following machine learning methods: a linear model, a decision tree, a neural network, a Gaussian process regression, a k-nearest neighbor method or a support vector machine.

12. The inductive proximity sensor (10) according to any of the preceding claims, wherein the machine learning method is trained with sensor signals in different sensor environments, in particular varying installation depth, installation material, object distance and object material.

13. The inductive proximity sensor (10) according to any of the preceding claims, wherein the control and evaluation unit (24) is configured to track the correction value over time and to adjust it based on its history, in particular with a prediction filter.

14. A method for evaluating a sensor signal of an inductive proximity sensor (10), wherein the sensor signal is detected and evaluated in order to determine an object property, a correction value for disturbing influences of the sensor environment being determined from the sensor signal in a further evaluation using a machine learning method, and the object property being corrected with the correction value.

15. The method according to claim 14,
wherein the machine learning method is trained in advance using sensor signals in different sensor environments, in particular with variation of installation depth, installation material, object distance and object material.

## Revendications

1. Capteur de proximité inductif (10) pour détecter un objet, le capteur de proximité inductif (10) comprenant une unité de détection (12, 22) pour détecter un signal de capteur et une unité de commande et d'évaluation (24) réalisée pour déterminer une propriété de l'objet par évaluation du signal de capteur, l'unité de commande et d'évaluation (24) comprenant une unité de valeur de correction (28) réalisée pour déterminer, à partir du signal de capteur, une valeur de correction pour les influences perturbatrices de l'environnement du capteur à l'aide d'une autre évaluation par un procédé d'apprentissage automatique, et pour corriger la propriété de l'objet avec la valeur de correction.

2. Capteur de proximité inductif (10) selon la revendication 1,
dans lequel l'unité de détection (12, 22) comprend au moins une bobine (12).

3. Capteur de proximité inductif (10) selon la revendication 1 ou 2, comprenant au moins une bobine (12, 14) pour générer un signal d'impulsion.

4. Capteur de proximité inductif (10) selon l'une des revendications précédentes,
comprenant un élément supplémentaire (14, 14a, 14b) pour modifier les propriétés de l'unité de détection ou, si pris en dépendance de la revendication 3, d'un signal d'impulsion généré et pour ainsi acquérir des informations supplémentaires sur l'environnement du capteur.

5. Capteur de proximité inductif (10) selon la revendication 4,
dans lequel l'élément supplémentaire (14, 14a, 14b) est une bobine verticale (14), une bobine coaxiale (14a) ou un anneau de court-circuit (14b).

6. Capteur de proximité inductif (10) selon l'une des revendications précédentes,
dans lequel l'unité de commande et d'évaluation (24) est réalisée pour déterminer comme propriété de l'objet un signal binaire de détection d'objet, le capteur (10) présentant en particulier une sortie de commutation (34) pour émettre le signal de détection d'objet comme signal de commutation.

7. Capteur de proximité inductif (10) selon l'une des revendications précédentes,
dans lequel un convertisseur A/N (22) est associé à l'unité de détection (12, 22) pour numériser le signal de capteur.

8. Capteur de proximité inductif (10) selon l'une des revendications précédentes,
dans lequel l'unité de commande et d'évaluation (24) est réalisée pour générer un signal intermédiaire à partir d'un signal de référence et du signal de capteur et pour déterminer la propriété de l'objet et/ou la valeur de correction à l'aide du signal intermédiaire, le signal de référence étant un signal de capteur propre du capteur (10), enregistré et mémorisé au préalable, ou un signal de capteur d'un capteur de référence.

9. Capteur de proximité inductif (10) selon l'une des revendications précédentes,
dans lequel l'unité de commande et d'évaluation (24) est réalisée pour générer un vecteur de caractéristique à partir du signal de capteur, en particulier après une transformation et/ou une réduction dimensionnelle.

10. Capteur de proximité inductif (10) selon l'une des revendications précédentes,
dans lequel l'unité de commande et d'évaluation (24) est réalisée pour intégrer le signal de capteur, en particulier pour comparer le signal de capteur intégré à une valeur seuil, la valeur de correction étant en particulier une valeur de correction pour le signal de capteur intégré.

11. Capteur de proximité inductif (10) selon l'une des revendications précédentes,
dans lequel l'unité de commande et d'évaluation (24) est réalisée pour l'un au moins des procédés d'apprentissage automatique suivants : un modèle linéaire, un arbre de décision, un réseau neuronal, une régression du processus de Gauss, une méthode des k plus proches voisins ou une machine à vecteurs de support.

12. Capteur de proximité inductif (10) selon l'une des revendications précédentes,
dans lequel le procédé d'apprentissage automatique est entraîné avec des signaux de capteur dans différents environnements du capteur, en particulier en faisant varier la profondeur de montage, le matériau de montage, la distance à l'objet et le matériau de l'objet.

13. Capteur de proximité inductif (10) selon l'une des revendications précédentes,
dans lequel l'unité de commande et d'évaluation (24) est réalisée pour suivre la valeur de correction dans le temps et l'adapter à l'aide de son historique, en particulier avec un filtre prédictif.

14. Procédé d'évaluation d'un signal de capteur d'un capteur de proximité inductif (10), le signal de capteur étant détecté et évalué pour déterminer une propriété de l'objet,
dans lequel une valeur de correction pour les influences perturbatrices de l'environnement du capteur est déterminée à partir du signal de capteur lors d'une autre évaluation à l'aide d'un procédé d'apprentissage automatique, et la propriété de l'objet est corrigée avec la valeur de correction.

15. Procédé selon la revendication 14,
dans lequel le procédé d'apprentissage automatique est préalablement entraîné avec des signaux de capteur dans différents environnements du capteur, en particulier en faisant varier la profondeur de montage, le matériau de montage, la distance à l'objet et le matériau de l'objet.
